(19) Europäisches Patentamt
European Patent Office
Office européen des brevets

(11) **EP 4 228 118 A1**

(12) **EUROPEAN PATENT APPLICATION**
published in accordance with Art. 153(4) EPC

(43) Date of publication:
**16.08.2023 Bulletin 2023/33**

(21) Application number: **21956346.7**

(22) Date of filing: **08.09.2021**

(51) International Patent Classification (IPC):
**H02J 7/00** $^{(2006.01)}$

(52) Cooperative Patent Classification (CPC):
**H02J 7/00**

(86) International application number:
**PCT/CN2021/117307**

(87) International publication number:
**WO 2023/035158 (16.03.2023 Gazette 2023/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Contemporary Amperex Technology
Co., Limited
Ningde City, Fujian 352100 (CN)**

(72) Inventors:
• **HUANG, Shan**
**Ningde, Fujian 352100 (CN)**
• **LI, Shichao**
**Ningde, Fujian 352100 (CN)**
• **LI, Haili**
**Ningde, Fujian 352100 (CN)**
• **ZHAO, Wei**
**Ningde, Fujian 352100 (CN)**
• **XIE, Lan**
**Ningde, Fujian 352100 (CN)**

(74) Representative: **Rowlands, Stuart Michael et al
Maucher Jenkins
Seventh Floor Offices
Artillery House
11-19 Artillery Row
London SW1P 1RT (GB)**

(54) **METHOD FOR CHARGING POWER BATTERY AND BATTERY MANAGEMENT SYSTEM**

(57)    Embodiments of the present application provide a method for charging a power battery and a battery management system. The method comprises: during a charging process of a power battery, obtaining the negative electrode potential of the power battery; and when a difference between the negative electrode potential and a preset potential is less than or equal to a safety threshold, controlling the power battery to discharge. The method and the battery management system in the embodiments of the present application may improve the safety performance of the power battery.

FIG. 2

**Description**

Technical Field

The present application relates to the field of battery technologies, and in particular, to a method for charging a power battery and a battery management system.

Background Art

With the development of the times, electric vehicles have huge market prospects due to their high environmental protection, low noise, and low usage cost, and can effectively promote energy conservation and emission reduction, which is conducive to the development and progress of society.

Battery technologies are an important factor for the development of electric vehicles and the related art, especially the safety performance of batteries, which affects the development and application of battery-related products, and affects the public acceptance of electric vehicles. Therefore, how to improve the safety performance of power batteries is a technical problem to be solved.

Summary of the Invention

Embodiments of the present application provide a method for charging a power battery and a battery management system, which can improve the safety performance of the power battery.

According to a first aspect, there is provided a method for charging a power battery, including: obtaining a negative electrode potential of a power battery during a charging process of the power battery; and controlling the power battery to be discharged when a difference between the negative electrode potential and a preset potential is less than or equal to a safety threshold.

The safety threshold is set, such that the BMS controls the power battery to be discharged when the difference between the negative electrode potential and the preset potential is less than or equal to the safety threshold, that is, the BMS controls the power battery to be discharged before the negative electrode potential reaches the preset potential, which may avoid precipitation of lithium metal on the surface of the negative electrode, so that the safety performance of the power battery can be improved.

In a possible implementation, the controlling the power battery to be discharged when a difference between the negative electrode potential and a preset potential is less than or equal to a safety threshold includes: when the difference between the negative electrode potential and the preset potential is less than or equal to the safety threshold, sending first charging request information to a charging pile, the first charging request information being used to request that a charging current be 0; and when a collected actual charging current of the power battery is less than or equal to a current threshold, controlling the power battery to be discharged.

When the collected actual charging current of the power battery is less than or equal to the current threshold, the power battery is controlled to be discharged, which is conducive to improving a suppressing effect of the discharging of the power battery on lithium precipitation of the battery.

In a possible implementation, the method further includes: when a duration elapsed after the first charging request information is sent is greater than or equal to a first time interval, controlling the power battery to stop being discharged.

In a possible implementation, the method further includes: when a duration for controlling the power battery to be discharged is greater than or equal to a second time interval, controlling the power battery to stop being discharged.

Controlling the power battery to be discharged for a specific period of time may minimize an impact on the charging efficiency under the premise of suppressing lithium precipitation, and at the same time may avoid abnormal gun unplugging due to long-time discharging.

In a possible implementation, the method further includes: when the power battery is controlled to stop being discharged, sending second charging request information to the charging pile based on a charging matching table, the second charging request information being used to request the charging pile to charge the power battery.

According to a second aspect, there is provided a battery management system, including: an obtaining module configured to obtain a negative electrode potential of a power battery during a charging process of the power battery; and a control module configured to control the power battery to be discharged when a difference between the negative electrode potential and a preset potential is less than or equal to a safety threshold.

In a possible implementation, the control module is specifically configured to: when the difference between the negative electrode potential and the preset potential is less than or equal to the safety threshold, send first charging request information to a charging pile, the first charging request information being used to request that a charging current be 0; and when a collected actual charging current of the power battery is less than or equal to a current threshold, control the power battery to be discharged.

In a possible implementation, the control module is further configured to: when a duration elapsed after the first charging request information is sent is greater than or equal to a first time interval, control the power battery to stop being discharged.

In a possible implementation, the control module is further configured to: when a duration for controlling the power battery to be discharged is greater than or equal to a second time interval, control the power battery to stop being discharged.

In a possible implementation, the battery management system further includes: a communication module configured to: when the power battery is controlled to stop being discharged, send second charging request information to the charging pile based on a charging matching table, the second charging request information being used to request the charging pile to charge the power battery.

According to a third aspect, there is provided a battery management system, including a memory and a processor, where the memory is configured to store instructions, and the processor is configured to read the instructions and perform, based on the instructions, the method in the first aspect or any of the possible implementations in the first aspect.

According to a fourth aspect, there is provided a readable storage medium configured to store a computer program, where the computer program is used to perform the method in the first aspect or any of the possible implementations in the first aspect.

Brief Description of the Drawings

In order to illustrate the technical solutions of the embodiments of the present application more clearly, the drawings required in the description of the embodiments of the present application will be described briefly below. It will be apparent that the drawings described below are merely some embodiments of the present application, and for those of ordinary skill in the art, other drawings can also be obtained from these drawings without any creative efforts.

FIG. 1 is a schematic block diagram of a battery system to which an embodiment of the present application is applicable;
FIG. 2 is a schematic block diagram of a method for charging a power battery according to an embodiment of the present application;
FIG. 3 is a schematic diagram of an electrode-split first-order RC equivalent circuit model according to an embodiment of the present application;
FIG. 4 is a schematic flowchart of a method for charging a power battery according to an embodiment of the present application;
FIG. 5 is a schematic block diagram of a battery management system according to an embodiment of the present application; and
FIG. 6 is another schematic block diagram of a battery management system according to an embodiment of the present application.

Detailed Description of Embodiments

The implementations of the present application will be further described in detail below in conjunction with the accompanying drawings and embodiments. The following detailed description of the embodiments and the accompanying drawings are used to illustrate the principle of the present application by way of example but should not be used to limit the scope of the present application. That is, the present application is not limited to the described embodiments.

In the description of the present application, it should be noted that "multiple" means two or more, unless otherwise specified. The orientation or position relationship indicated by the terms "upper", "lower", "left", "right", "inner", "outer", etc. is only for the convenience of describing the present application and simplifying the description, rather than indicating or implying that the apparatus or element referred to must have a particular orientation or be constructed and operated in a particular orientation, and therefore should not be construed as a limitation on the present application. In addition, the terms "first", "second", "third", etc. are used for descriptive purposes only, and should not be construed as indicating or implying the relative importance. The term "perpendicular" does not mean being perpendicular in the strict sense, but within an allowable range of errors. The term "parallel" does not mean being parallel in the strict sense, but within an allowable range of errors.

The orientation terms in the following description all indicate directions shown in the drawings, but do not limit the specific structure in the present application. In the description of the present application, it should also be noted that the terms "disposing", "connecting", and "connection" should be interpreted in the broad sense unless explicitly defined and limited otherwise. For example, the terms may mean a fixed connection, a detachable connection, or an integral connection, or may mean a direct connection, or an indirect connection by means of an intermediate medium. For those of ordinary skill in the art, the specific meanings of the terms mentioned above in the present application can be construed according to specific circumstances.

In the new energy field, a power battery is used as a main power source for a power consuming apparatus, such as a vehicle, a ship, or a spacecraft. The importance of power batteries is self-evident. At present, most of the power batteries on the market are rechargeable batteries, and the common ones are lithium-ion batteries or lithium ion polymer batteries.

Generally, during the charging process of a lithium-ion battery, lithium ions may be deintercalated from the positive electrode and intercalated into the negative electrode, but when some abnormal conditions occur (for example, the battery is being charged at a low temperature, or the battery is being charged at a large charging rate or charging voltage), and consequently the lithium ions deintercalated from the positive electrode cannot be intercalated into the negative electrode, the lithium ions can only be precipitated on the surface of the negative electrode, thus forming a layer of gray substance. This phenomenon is called lithium precipitation.

Lithium precipitation may not only reduce the performance and the cycle life of the battery, but also limit the fast charging capacity of the battery, and may cause disastrous consequences such as combustion and explosion.

In view of this, an embodiment of the present application provides a method for charging a power battery, which is conducive to resolve the problem of lithium precipitation of power batteries, so as to improve the performance of the power batteries.

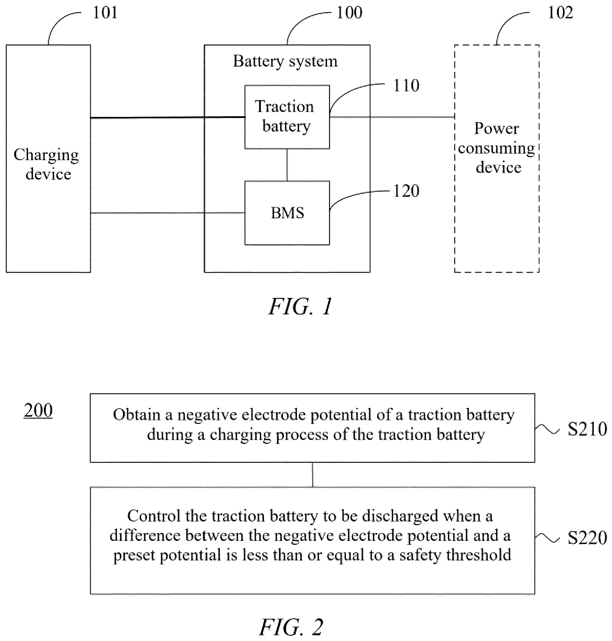

FIG. 1 shows a battery system 100 to which an embodiment of the present application is applicable. The battery system 100 may include: a power battery 110 and a battery management system (BMS) 120.

Specifically, the power battery 110 may include at least one battery module, which can provide energy and power for an electric vehicle. In terms of a battery type, the power battery 110 may be a lithium-ion battery, a lithium metal battery, a lead-acid battery, a nickel-chromium battery, a nickel-hydrogen battery, a lithium-sulfur battery, a lithium-air battery, a sodium-ion battery, or the like, which is not specifically limited in the embodiments of the present application. In terms of a battery size, in the embodiments of the present application, the battery module in the power battery 110 may be a cell/battery cell, or may be a battery bank or a battery pack, which is not specifically limited in the embodiments of the present application.

In addition, to intelligently manage and maintain the power battery 110, prevent the battery from failures, and prolong the service life of the battery, the battery system 100 is generally provided with a BMS 120. The BMS 120 is connected to the power battery 110 and configured to monitor and collect a parameter of the power battery 110, and the BMS 120 may further implement control and management of the power battery 110 based on the parameter.

As an example, the BMS 120 may be configured to monitor parameters such as voltage, current, and temperature of the power battery 110. The BMS 120 may collect, in real time, a total voltage and a total current of the power battery 110, a voltage and a current of a single battery cell in the power battery 110, a temperature at at least one temperature measurement point in the power battery 110, etc. The real-time, fast, and accurate measurement of the parameters is the basis for the normal operating of the BMS 120.

Optionally, the BMS 120 may further estimate the state of charge (SOC), state of health (SOH), state of power (SOP), and other parameters of the power battery 110 based on the collected parameters of the power battery 110.

Further, after obtaining a plurality of parameters of the power battery 110, the BMS 120 may implement, based on the plurality of parameters, control and management of the power battery 110 in various manners.

For example, the BMS 120 may control the charging and discharging of the power battery 110 based on parameters such as SOC, voltage, and current, so as to ensure normal energy supply and release of the power battery 110.

For another example, the BMS 120 may further control components such as a cooling fan or a heating module based on parameters such as temperature, so as to implement thermal management of the power battery 110.

For still another example, the BMS 120 may further determine, based on parameters such as voltage and SOH, whether the power battery 110 is in a normal operating state, so as to implement fault diagnosis and early warning for the power battery 110.

Optionally, as shown in FIG. 1, the battery system 100 may establish a connection with a charging device 101 and a power consuming device 102, so as to implement charging and discharging of the power battery 100.

Optionally, the charging device 101 may include, but is not limited to, a charging pile, which may also be called a charger.

Optionally, the power consuming device 102 may include, but is not limited to, an electric vehicle or an external device.

FIG. 2 is a schematic block diagram of a method 200 for charging a power battery according to an embodiment of the present application. Optionally, the power battery in the embodiment of the present application may be the power battery 110 shown in FIG. 1, and the method 200 may be applied to the BMS 120 in the battery system 100 shown in FIG. 1, that is, the method 200 may be performed by the BMS 120 in the battery system 100 shown in FIG. 1. Specifically, as shown in FIG. 2, the method 200 includes a part or all of the following content:

S210: obtaining a negative electrode potential of a power battery during a charging process of the power battery; and
S220: controlling the power battery to be discharged when a difference between the negative electrode potential and a preset potential is less than or equal to a safety threshold.

It should be understood that an electrode generally refers to a location in a battery where an oxidation-reduction reaction with an electrolyte solution occurs. The electrode is divided into a positive electrode and a negative electrode. Generally, the positive electrode is the cathode, which gains electrons and undergoes a reduction reaction; and the negative electrode is the anode, which loses electrons and undergoes an oxidation reaction. In other words, the negative electrode potential may also be referred to as an anode potential and the positive electrode potential may also be referred to as a cathode potential.

Generally, during the charging process of the power battery, the negative electrode potential of the power battery may gradually decrease. When the negative electrode potential of the power battery decreases to the preset potential, lithium metal may be precipitated. The preset potential may also be referred to as a lithium precipitation potential, that is, a critical potential for lithium precipitation. A lithium-ion battery of a graphite negative electrode system is used as an example, in which the electrodes of the lithium-ion battery are polarized during the charging process, that is, a negative electrode potential decreases, while a positive electrode potential increases, and when the negative electrode potential decreases to 0 V (vs Li/Li$^+$), lithium metal may be precipitated on the surface of the negative electrode, which damages the performance of the battery, and may cause safety accidents such as thermal runaway in severe cases.

The applicant has found that during the charging process of the power battery, controlling the power battery to be discharged can facilitate reintercalation of lithium metal and suppress continuous accumulation of precipitated lithium metal. However, because the BMS requires a specific response time to control the power battery to be discharged, for example, the BMS may need to first determine, through negotiation with the charging pile, to stop charging the power battery, and then the power battery can start to be discharged. Therefore, if the BMS controls the power battery to be discharged when the negative electrode potential of the power battery reaches the preset potential, lithium metal may still be precipitated on the surface of the negative electrode, thereby damaging the performance of the battery.

In the embodiment of the present application, the safety threshold is set, such that the BMS controls the power battery to be discharged when the difference between the negative electrode potential and the preset potential is less than or equal to the safety threshold, that is, the BMS controls the power battery to be discharged before the negative electrode potential reaches the preset potential, which may avoid precipitation of lithium metal on the surface of the negative electrode before the power battery is discharged, so that the safety performance of the battery can be improved.

Optionally, in the embodiment of the present application, the safety threshold cannot be too large, that is, the BMS cannot control the power battery to be discharged when the negative electrode potential of the power battery is far from decreasing to the preset potential. In this case, although precipitation of lithium metal on the surface of the negative electrode may be avoided, the charging efficiency may be affected. Optionally, the safety threshold may be set based on battery performance, charging speed requirements, safety requirements, etc., for example, the safety threshold may be 5 mV, 10 mV, or 15 mV.

Optionally, in the embodiment of the present application, the accuracy of the obtained negative electrode potential may also be considered in the setting of the safety threshold, that is, an error of the negative electrode potential.

In S210, the obtaining of the negative electrode potential of the power battery is not specifically limited. For example, the negative electrode potential of the battery may be obtained by estimation using a negative electrode potential estimation model, or may be obtained through actual measurement on a three-electrode battery with a reference electrode.

In an embodiment, for a two-electrode battery, the BMS may separate a positive electrode from a negative electrode of the battery by using a negative electrode potential estimation model, so as to accurately simulate change rules of a negative electrode potential and a positive electrode potential of the battery during a charging process. For example, an equivalent circuit model, an electrochemical model, and an equivalent circuit and electro-chemical coupling model, etc. may be used.

In another embodiment, the BMS may obtain the negative electrode potential of the battery by collecting a negative electrode potential of the three-electrode battery with the reference electrode and a potential of the reference electrode, where the three-electrode battery is a battery that has one more reference electrode than a conventional two-electrode battery with a positive electrode and a negative electrode, and the reference electrode is, for example, a lithium metal reference electrode, a lithium alloy reference electrode, or a copper wire in-situ lithium-plated reference electrode.

Specifically, the BMS may establish an electrode-split equivalent model of the three-electrode battery, and the electrode-split equivalent model may include a positive electrode parameter and a negative electrode parameter, so as to respectively reflect an external characteristic and an internal characteristic of the three-electrode battery, thereby helping accurately predict the negative electrode potential. The electrode-split equivalent model may include a Rint model, an electrode-split first-order RC equivalent circuit model, an electrode-split second-order RC equivalent circuit model, and the like.

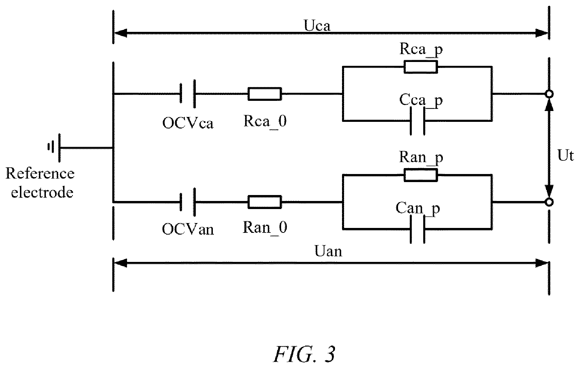

FIG. 3 is a schematic diagram of an electrode-split first-order RC equivalent circuit model according to an embodiment of the present application. As shown in FIG. 3, Ut represents a terminal voltage of a full battery; Uca and Uan respectively represent a potential of a positive electrode relative to a reference electrode and a potential of a negative electrode relative to the reference electrode; OCVca and OCVan respectively represent an open-circuit voltage of the positive electrode and an open-circuit voltage of the negative electrode; Rca_0 and Ran_0 respectively represent an ohmic internal resistance of the positive electrode and an ohmic internal resistance of the negative electrode; Uca_p and Uan_p respectively represent a polarization voltage of the positive electrode and a polarization voltage of the negative electrode; Rca_p and Ran_p respectively represent a polarization internal resistance of the positive electrode and a polarization internal resistance of the negative electrode; Cca_p and Can_p respectively represent a polarization capacitance of the positive electrode and a polarization capacitance of the negative electrode; I represents a current; and Uca_p' and Uan_p' respectively represent the derivatives of Uca_p and Uan_p.

First, the open-circuit voltage OCVca of the positive electrode and the open-circuit voltage OCVan of the negative electrode may be obtained through actual measurement, then model parameters Rca_0, Ran_0, Rca_p, Ran_p, Cca_p, and Can_p may be calibrated according to formulas (1) to (5) in conjunction with optimization algorithms such as the least square method, the genetic algorithm, etc., and finally a negative electrode potential is estimated by using the extended Kalman filter algorithm, the proportional-integral-derivative (PID) algorithm, or a Luenberger observer.

$$Ut = Uca - Uan \qquad (1)$$

$$Uca = OCVca + I * Rca\_0 + Uca\_p \qquad (2)$$

$$Uan = OCVan + I * Ran\_0 + Uan\_p \qquad (3)$$

$$Uca\_p' = I / Cca\_p - Uca\_p/(Rca\_p * Cca\_p) \qquad (4)$$

$$Uan\_p' = I / Can\_p - Uan\_p/(Ran\_p * Can\_p) \qquad (5)$$

An embodiment of estimating a negative electrode potential by using the extended Kalman filter algorithm is briefly described below. The extended Kalman filter algorithm is mainly composed of the state equation (6) and the observation equation (7), and the time and state are iteratively updated according to the recursive equations (8) to (12), so as to implement state estimation.

$$X_{k+1} = A_k X_k + B_k U_k + Q_k \qquad (6)$$

$$Y_k = C_k X_k + R_k \qquad (7)$$

$$\hat{X}_k^- = A_{k-1}\hat{X}_{k-1} + B_{k-1}U_{k-1} \qquad (8)$$

$$P_k^- = A_{k-1}P_{k-1}A_{k-1}^T + Q \qquad (9)$$

$$K_k = P_k^- C_k^T (C_k P_k^- C_k^T + R)^{-1} \qquad (10)$$

$$\hat{X}_k = \hat{X}_k^- + K_k(Y_k - C_k\hat{X}_k^- - D_k U_k) \qquad (11)$$

$$P_k = (1 - K_k C_k)P_k^- \qquad (12)$$

where X represents a state quantity to be estimated, U represents a controllable input quantity, Y represents an output quantity, Q and R respectively represent a system error and a measurement error, P represents a covariance matrix of an estimated error, the subscript k represents a variable at the moment k, and the superscript T represents a transposition operation on the matrix. A, B, C and D represent coefficient matrices.

The values of X, A, B, C, Q, and R are substituted into the above equations:

$$X_k = \begin{bmatrix} SOC_k \\ Uan\_p_k \\ Uca\_p_k \\ Uan_k \end{bmatrix}$$

$$A_k = \begin{bmatrix} 1 & 0 & 0 & 0 \\ 0 & e^{-\left(\frac{dt}{Ran\_p*Can\_p}\right)} & 0 & 0 \\ 0 & 0 & e^{-\left(\frac{dt}{Rca\_p*Cca\_p}\right)} & 0 \\ d(OCVan_k)/d(SOC_k) & e^{-\left(\frac{dt}{Ran\_p*Can\_p}\right)} & 0 & 0 \end{bmatrix}$$

$$B_k = \begin{bmatrix} dt/(3600*Cap) \\ Ran\_p*(1 - e^{-\left(\frac{dt}{Ran\_p*Can\_p}\right)}) \\ Rca\_p*(1 - e^{-\left(\frac{dt}{Rca\_p*Cca\_p}\right)}) \\ Ran\_p*\left(1 - e^{-\left(\frac{dt}{Ran\_p*Can\_p}\right)}\right) + Ran\_0 \end{bmatrix}$$

$$C_k = \begin{bmatrix} d(OCVan_k + OCVca_k)/d(SOC_k) \\ 1 \\ 1 \\ 0 \end{bmatrix}$$

$$Q_k = \begin{bmatrix} 0 & 0 & 0 & 0 \\ 0 & 0 & 0 & 0 \\ 0 & 0 & 0 & 0 \\ 0 & 0 & 0 & 0 \end{bmatrix}$$

$$R_k = 0.01$$

In other words, the negative electrode potential can be obtained by using a negative electrode potential estimation equation:

$$Uan_k = \frac{d(OCVan_k)}{d(SOC_k)} * SOC_k + Uan\_p_k * e^{-\left(\frac{dt}{Ran\_p*Can\_p}\right)} + Ran\_p * \left(1 - e^{-\left(\frac{dt}{Ran\_p*Can\_p}\right)}\right) +$$

$$Ran\_0.$$

The SOC can be obtained by using the ampere-hour integration method.

Optionally, in the embodiment of the present application, when the BMS controls the power battery to be discharged, parameters such as the magnitude of a discharging current, a discharging duration, etc. of the power battery may be fixed, or may be adjusted in real time.

In an example, the BMS may control, based on the same discharging parameter, the power battery to be discharged. For example, the discharging parameter may be fixed and configured as a current of 10 A and a discharging duration of 20s.

In another example, the BMS may control, based on a discharging parameter determined in real time, the power battery to be discharged. For example, the discharging parameter of the power battery may be determined based on a state parameter of the power battery. The state parameters of the power battery may include, for example, temperature, SOC, SOH, etc.

Optionally, the discharging parameter of the power battery may be determined based on an SOC interval of the SOC of the power battery. Generally, the greater the SOC of the power battery, the higher the risk of lithium precipitation of the battery. The BMS may configure in advance discharging durations and/or discharging currents corresponding to different SOC intervals. For example, a discharging duration corresponding to a high SOC interval may be greater than a discharging duration corresponding to a low SOC interval. For another example, a discharging current corresponding to a high SOC interval may be greater than a discharging current corresponding to a low SOC interval.

Dynamically adjusting the discharging parameter of the power battery based on the state parameter of the power battery may better balance a relationship between lithium precipitation and a charging speed, so that fast and safe charging can be better implemented.

It should be noted that determining the discharging parameter of the power battery and controlling the power battery to be discharged may be considered as two independent steps that do not interfere with each other. In other words, there is no necessary time sequence relationship between determining a discharging parameter of the power battery and controlling the power battery to be discharged. If the discharging parameter of the power battery is determined first, the power battery is controlled, based on the determined discharging parameter, to be discharged; or if the discharging parameter of the power battery is not determined first, the power battery is controlled, based on the last determined discharging parameter, to be discharged.

Optionally, in the embodiment of the present application, the method 200 further includes: when the difference between the negative electrode potential and the preset potential is less than or equal to the safety threshold, sending first charging request information to a charging pile, the first charging request information being used to request that a charging current be 0; and when a collected actual charging current of the power battery is less than or equal to a current threshold, controlling the power battery to be discharged.

Generally, when the BMS is physically connected to a charging pile and powered on, a low-voltage auxiliary power supply is turned on, so that they enter a handshake startup phase, and send handshake packets, and insulation monitoring is then performed. After the insulation monitoring is completed, they enter a handshake identification phase and may each send an identification packet, to determine necessary information about the power battery and the charging pile. After the charging handshake phase, the charging pile and the BMS enter a charging parameter configuration phase. In this phase, the charging pile may send a packet about a maximum output capability of the charging pile to the BMS, so that the BMS may determine, based on the maximum output capability of the charging pile, whether the charging pile can perform charging. After the charging parameter configuration phase, the charging pile and the BMS may enter a charging phase.

During the charging process of the power battery, the BMS may send a battery charging requirement to the charging pile, and the charging pile may adjust a charging voltage and a charging current based on the battery charging requirement, to ensure a normal charging process. As an example, the battery charging requirement may carry a requested charging current. Then, the charging pile may output a current to the power battery based on the requested charging current sent by the BMS, and the BMS may collect a charging current of the power battery, that is, the actual charging current in the embodiment of the present application.

In the embodiment of the present application, the first charging request information is similar to a battery charging requirement, except that a requested charging current carried in the battery charging requirement is 0, that is, the first charging request information is used to request the charging pile for a charging current of 0. After receiving the first charging request information, the charging pile controls a charging current output to the power battery to be 0. Since the actual charging current of the power battery gradually decreases after the BMS sends the first charging request information to the charging pile, if the BMS controls the power battery to be discharged immediately after the first charging request information is sent to the charging pile, a suppressing effect of discharging on lithium precipitation of the battery may be reduced.

In an example, the actual charging current of the power battery is collected in real time, so that when the actual charging current is less than or equal to the current threshold, the power battery is controlled to be discharged. For example, the current threshold is 50 A.

In another example, the power battery may alternatively be controlled to be discharged after a preset duration elapsed after the first charging request information is sent to the charging pile. The preset duration may be based on an empirical value of a duration from the moment when the BMS sends the first charging request information to the charging pile to the moment when the actual charging current of the power battery decreases to the current threshold.

Optionally, in an embodiment of the present application, the method 200 further includes: when the duration elapsed after the first charging request information is sent is greater than or equal to a first preset time interval, controlling the power battery to stop being discharged.

For example, a timer may be started when the BMS sends the first charging request information to the charging pile, a duration of the timer may be the first preset time interval, and when the timer expires, the power battery is controlled to stop being discharged. For example, the duration of the timer may be 60s, that is, the first preset time interval is 60s.

For another example, timing may be started when the BMS sends the first charging request information to the charging pile, and when a timing duration reaches the first preset time interval, the power battery is controlled to stop being discharged. For example, the first preset time interval is 60s.

Optionally, in another embodiment of the present application, the method 200 further includes: when a duration for controlling the power battery to be discharged is greater than or equal to a second preset time interval, controlling the power battery to stop being discharged.

For example, the timer may be started at a moment when the BMS starts to control the power battery to be discharged, a duration of the timer may be the second preset time interval, and when the timer expires, the power battery is controlled to stop being discharged. For example, the duration of the timer may be 20s, that is, the second preset time interval is 20s.

For another example, timing may be started when the BMS controls the power battery to start to be discharged, and when a timing duration reaches the second preset time interval, the power battery is controlled to stop being discharged. For example, the second preset time interval is 20s.

It should be understood that the first preset time interval and the second preset time interval may be configured.

Controlling the power battery to be discharged within a specific period of time may minimize an impact on the charging efficiency under the premise of suppressing lithium precipitation, and at the same time may avoid abnormal gun unplugging due to long-time discharging.

Optionally, in the embodiment of the present application, the method 200 further includes: when the power battery is controlled to stop being discharged, sending second charging request information to the charging pile based on a charging matching table, the second charging request information being used to request the charging pile to charge the power battery.

Specifically, when controlling the power battery to stop being discharged, the BMS may send the second charging request information to the charging pile based on the charging matching table. The second charging request information is similar to the battery charging requirement described above, and a requested charging current carried in the second charging request information is not 0, that is, the charging pile is requested to output a current to the power battery. In other words, the BMS may store a charging matching table, the charging matching table may include correspondences between requested charging currents and various state parameters of the power battery. When the BMS controls the power battery to stop being discharged, the corresponding requested charging current may be obtained from the charging matching table based on a current state parameter of the power battery, and sent to the charging pile by using the second charging request information. For example, the BMS may obtain, from the charging matching table, a requested charging current corresponding to the current SOC. After receiving the second charging request information, the charging pile outputs a non-zero charging current to the power battery, that is, the charging pile charges the power battery. Further, the BMS may repeat steps 210 and 220.

Optionally, in the embodiment of the present application, the method 200 further includes: when the power battery is in a fully-charged state or a gun-unplugged state, controlling the power battery to be discharged.

If the power battery is in the fully-charged state or the gun-unplugged state, since it is unclear at this time whether the power battery in the current state has a risk of lithium precipitation, the power battery is controlled to be discharged, which may suppress lithium precipitation when the power battery has the risk of lithium precipitation, so that the safety performance of the power battery can be improved.

It should be noted that an object to which the power battery is discharged may be, for example, the power consuming device 102 shown in FIG. 1 or a charging pile, which is not limited in the embodiment of the present application.

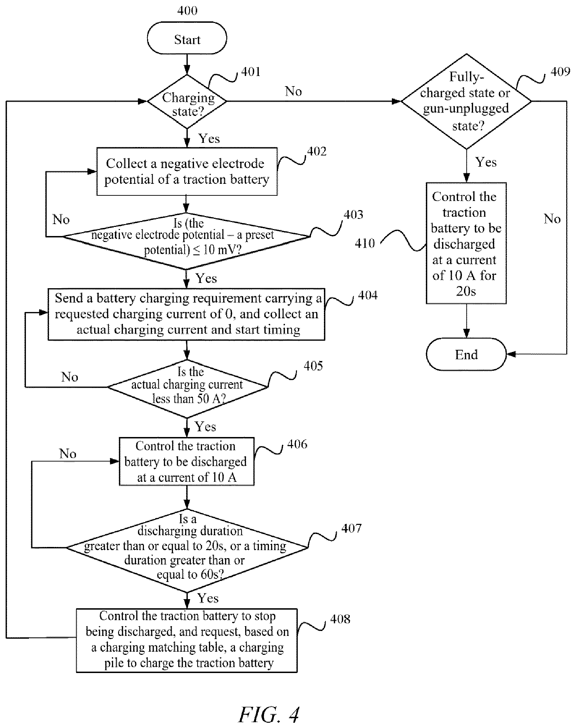

FIG. 4 is a schematic flowchart of a method 400 for charging a power battery according to an embodiment of the present application. As shown in FIG. 4, the method 400 may be performed by a BMS, and the method 400 may include a part or all of the following content.

In S401, whether a power battery is in a charging state is determined.

In S402, if it is determined in S401 that the power battery is in the charging state, the BMS collects a negative electrode potential of the power battery in real time, for example, obtains the negative electrode potential of the power battery through actual measurement on the above three-electrode battery.

Optionally, if it is determined in S401 that the power battery is not in the charging state, step S409 is performed.

In S403, whether (the negative electrode potential - a preset potential) is less than or equal to a safety threshold is determined, where the safety threshold is, for example, 10 mV.

In S404, if a determining result in S403 is yes, a battery charging requirement carrying a requested charging current of 0 is sent to a charging pile, and an actual charging current of the power battery is collected in real time and timing is started.

Optionally, if the determining result in S403 is no, step S402 is performed.

In S405, whether the actual charging current of the power battery is less than 50 A is determined.

In S406, if a determining result in S405 is yes, the power battery is controlled to be discharged at a current of 10 A.

Optionally, if the determining result in S405 is no, step S404 is performed.

In S407, whether a discharging duration of the power battery is greater than or equal to 20s is determined, or whether a timing duration in step S404 is greater than or equal to 60s is determined.

In S408, if a determining result in S407 is yes, the power battery is controlled to stop being discharged, and the charging pile is requested, based on a charging matching table, to charge the power battery. Then, step S401 is performed.

Optionally, if the determining result in S407 is no, step S406 is performed.

In S409, if it is determined in S401 that the power battery is in a non-charging state, whether the power battery is in a fully-charged state or a gun-unplugged state is determined.

In S410, if it is determined in S409 that the power battery is in the fully-charged state or the gun-unplugged state, the power battery is controlled to be discharged at a current of 10 A for 20s.

Optionally, if it is determined in S409 that the power battery is not in the fully-charged state or the gun-unplugged state, the method 400 ends.

It should be understood that, in the embodiments of the present application, sequence numbers of the foregoing processes do not mean execution sequences. The execution sequences of the processes should be determined according to functions and internal logic of the processes, and should not be construed as any limitation on the implementation processes of the embodiments of the present application.

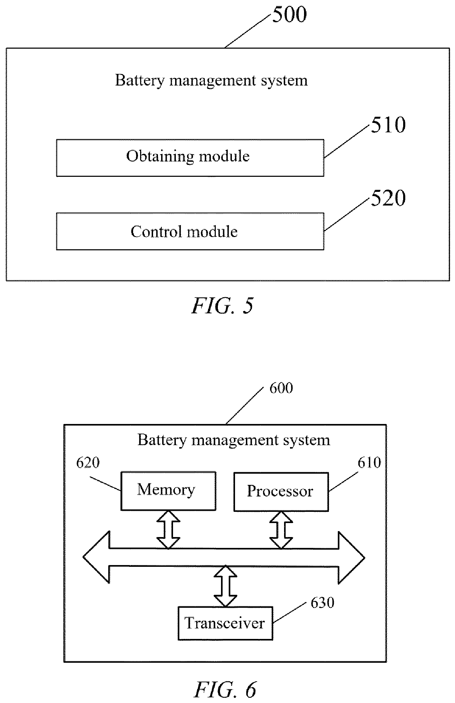

The method for charging a power battery according to the embodiments of the present application is described above in detail. A battery management system according to an embodiment of the present application is described below in detail with reference to FIG. 5 and FIG. 6. The technical features described in the method embodiments are applicable to the following apparatus embodiments.

FIG. 5 is a schematic block diagram of a battery management system 500 according to an embodiment of the present application. As shown in FIG. 5, the battery management system 500 includes:

an obtaining module 510 configured to obtain a negative electrode potential of a power battery during a charging process of the power battery; and

a control module 520 configured to control the power battery to be discharged when a difference between the negative electrode potential and a preset potential is less than or equal to a safety threshold.

In the embodiment of the present application, the safety threshold is set, such that the BMS controls the power battery to be discharged when the difference between the negative electrode potential and the preset potential is less than or equal to the safety threshold, that is, the BMS controls the power battery to be discharged before the negative electrode potential reaches the preset potential, which may avoid precipitation of lithium metal on the surface of the negative electrode before the power battery is discharged, so that the safety performance of the battery can be improved.

Optionally, in the embodiment of the present application, the control module 520 is specifically configured to: when the difference between the negative electrode potential and the preset potential is less than or equal to the safety threshold, send first charging request information to a charging pile, the first charging request information being used to request that a charging current be 0; and when a collected actual charging current of the power battery is less than or equal to a current threshold, control the power battery to be discharged.

Optionally, in the embodiment of the present application, the control module 520 is further configured to: when a duration elapsed after the first charging request information is sent is greater than or equal to a first time interval, control the power battery to stop being discharged.

Optionally, in the embodiment of the present application, the control module 520 is further configured to: when a duration for controlling the power battery to be discharged is greater than or equal to a second time interval, control the power battery to stop being discharged.

Optionally, in the embodiment of the present application, the battery management system 500 further includes: a communication module configured to: when the power battery is controlled to stop being discharged, send second charging request information to the charging pile based on a charging matching table, the second charging request information being used to request the charging pile to charge the power battery.

It should be understood that the battery management system 500 according to the embodiment of the present application may correspond to the BMS in the method embodiments of the present application, and the above and other operations and/or functions of the units in the battery management system 500 are used to implement the corresponding processes of the battery management system in the methods in FIG. 2 and FIG. 4, and will no longer be described herein for the purpose of brevity.

FIG. 6 is a schematic block diagram of a battery management system 600 according to another embodiment of the present application. As shown in FIG. 6, the battery management system 600 includes a processor 610 and a memory 620, where the memory 620 is configured to store instructions, and the processor 610 is configured to read the instructions and perform the method in the above embodiments of the present application based on the instructions.

The memory 620 may be a separate component independent of the processor 610, or may be integrated into the processor 610.

Optionally, as shown in FIG. 6, the battery management system 600 may further include a transceiver 630, and the processor 610 may control the transceiver 630 to communicate with another device such as a charging pile. Specifically, information or data may be sent to the another device, or information or data sent by the another device may be received.

An embodiment of the present application further provides a readable storage medium configured to store a computer program, where the computer program is used to execute the methods of the above embodiments of the present application.

Those of ordinary skill in the art may realize that units and algorithm steps of various examples described with reference to the embodiments disclosed in this specification can be implemented by using electronic hardware, or a combination of computer software and electronic hardware. Whether these functions are implemented in hardware or software depends on specific applications and design constraints of the technical solutions. A person skilled in the art may use different methods to implement the described functions for each particular application, but it should not be considered that the implementation goes beyond the scope of the present application.

A person skilled in the art can clearly understand that, for the convenience and brevity of the description, references can be made to the corresponding process in the foregoing method embodiment for the specific working process of the system, the apparatus and the unit described above, and details are not described herein again.

In the several embodiments provided in the present application, it should be understood that the disclosed system, apparatus and method can be achieved by other methods. For example, the described apparatus embodiments are merely examples. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separated, and parts displayed as units may or may not be physical units, that is, they may be located in one position, or may be distributed on a plurality of network units. Some or all of the units may be selected according to actual requirements to achieve the objectives of the solutions of the embodiments.

In addition, various functional units in the various embodiments of the present application may be integrated into one processing unit, or various units may be physically present separately, or two or more units may be integrated into one unit.

The functions, if implemented in the form of a software functional unit and sold or used as an independent product, may be stored in a computer-readable storage medium. Based on such understanding, the technical solution of the present application, in essence or the contribution to the prior art, or part of the technical solution may be embodied in the form of a software product. The computer software product is stored in a storage medium, and includes a plurality of instructions used to cause a computer device (which may be a personal computer, a server, or a network device, etc.) to perform all or part of the steps of the method described in various embodiments of the present application. The storage medium includes: a USB flash disk, a mobile hard disk, a read-only memory (ROM), a random access memory (RAM), or a magnetic disk or optical disc or other various media capable of storing program codes.

The above description is only specific embodiments of the present application, but the protection scope of the present application is not limited thereto, and variations and replacements that can be easily conceived within the technical scope disclosed in the present application by any person skilled in the art should fall within the protection scope of the present application. Therefore, the protection scope of the present application shall be subject to the protection scope of the claims.

**Claims**

1. A method for charging a power battery, comprising:

    obtaining a negative electrode potential of a power battery during a charging process of the power battery; and
    controlling the power battery to be discharged when a difference between the negative electrode potential and a preset potential is less than or equal to a safety threshold.

2. The method according to claim 1, wherein the controlling the power battery to be discharged when a difference between the negative electrode potential and a preset potential is less than or equal to a safety threshold comprises:

when the difference between the negative electrode potential and the preset potential is less than or equal to the safety threshold, sending first charging request information to a charging pile, the first charging request information being used to request that a charging current be 0; and
when a collected actual charging current of the power battery is less than or equal to a current threshold, controlling the power battery to be discharged.

3. The method according to claim 2, further comprising:
when a duration elapsed after the first charging request information is sent is greater than or equal to a first time interval, controlling the power battery to stop being discharged.

4. The method according to claim 1 or 2, further comprising:
when a duration for controlling the power battery to be discharged is greater than or equal to a second time interval, controlling the power battery to stop being discharged.

5. The method according to claim 3 or 4, further comprising:
when the power battery is controlled to stop being discharged, sending second charging request information to the charging pile based on a charging matching table, the second charging request information being used to request the charging pile to charge the power battery.

6. A battery management system, comprising:

an obtaining module configured to obtain a negative electrode potential of a power battery during a charging process of the power battery; and
a control module configured to control the power battery to be discharged when a difference between the negative electrode potential and a preset potential is less than or equal to a safety threshold.

7. The battery management system according to claim 6, wherein the control module is specifically configured to:

when the difference between the negative electrode potential and the preset potential is less than or equal to the safety threshold, send first charging request information to a charging pile, the first charging request information being used to request that a charging current be 0; and
when a collected actual charging current of the power battery is less than or equal to a current threshold, control the power battery to be discharged.

8. The battery management system according to claim 7, wherein the control module is further configured to:
when a duration elapsed after the first charging request information is sent is greater than or equal to a first time interval, control the power battery to stop being discharged.

9. The battery management system according to claim 6 or 7, wherein the control module is further configured to:
when a duration for controlling the power battery to be discharged is greater than or equal to a second time interval, control the power battery to stop being discharged.

10. The battery management system according to claim 8 or 9, further comprising:
a communication module configured to: when the power battery is controlled to stop being discharged, send second charging request information to the charging pile based on a charging matching table, the second charging request information being used to request the charging pile to charge the power battery.

11. A battery management system for a power battery, comprising a memory and a processor, wherein the memory is configured to store instructions, and the processor is configured to read the instructions and perform, based on the instructions, the method according to any one of claims 1 to 5.

FIG. 1

```
        101                      100                      102
```

| Charging device | | Battery system | | Power consuming device |

Traction battery — 110

BMS — 120

*FIG. 1*

200

| Obtain a negative electrode potential of a traction battery during a charging process of the traction battery | S210 |

| Control the traction battery to be discharged when a difference between the negative electrode potential and a preset potential is less than or equal to a safety threshold | S220 |

*FIG. 2*

*FIG. 3*

400

Start

401

Charging state? —No→ Fully-charged state or gun-unplugged state? 409

↓ Yes

Collect a negative electrode potential of a traction battery 402

↓

No← Is (the negative electrode potential – a preset potential) ≤ 10 mV? 403

410 Control the traction battery to be discharged at a current of 10 A for 20s

↓ Yes

Send a battery charging requirement carrying a requested charging current of 0, and collect an actual charging current and start timing 404

↓

No← Is the actual charging current less than 50 A? 405

End

↓ Yes

No← Control the traction battery to be discharged at a current of 10 A 406

↓

No← Is a discharging duration greater than or equal to 20s, or a timing duration greater than or equal to 60s? 407

↓ Yes

Control the traction battery to stop being discharged, and request, based on a charging matching table, a charging pile to charge the traction battery 408

*FIG. 4*

500

Battery management system

Obtaining module ⟋510

Control module ⟋520

*FIG. 5*

600

Battery management system

620
Memory

610
Processor

Transceiver ⟋630

*FIG. 6*

**INTERNATIONAL SEARCH REPORT**

| International application No. |
|---|
| **PCT/CN2021/117307** |

| A. | CLASSIFICATION OF SUBJECT MATTER |
|---|---|

H02J 7/00(2006.01)i

According to International Patent Classification (IPC) or to both national classification and IPC

| B. | FIELDS SEARCHED |
|---|---|

Minimum documentation searched (classification system followed by classification symbols)

H02J7/-

Documentation searched other than minimum documentation to the extent that such documents are included in the fields searched

Electronic data base consulted during the international search (name of data base and, where practicable, search terms used)

WPABSC; CNTXT; CNABS; ENTXTC; DWPI; WPABS; VEN; ENTXT; OETXT; CNKI; IEEE: 宁德时代新能源科技股份有限公司, 黄珊, 李世超, 李海力, 赵微, 谢岚, 锂, 电池, 电芯, 负极, 阳极, 电压, 电势, 电位, 充电, 放电, 电流, 负脉冲, 反向脉冲, 反向充电, 阈值, 阀值, 门限值, 析锂, 锂沉积, 锂沉淀, 极化, Li, lithium, precipitation, battery, charg+, discharg+, threshold, reverse, voltage, negative, potential, current, pulse, anode, cathode.

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 111279573 A (SZ DJI TECHNOLOGY CO., LTD.) 12 June 2020 (2020-06-12) description, paragraphs 24-137, and figures 1-9 | 1-11 |
| A | CN 106663957 A (GUANGDONG OPPO MOBILE TELECOMMUNICATIONS CO., LTD.) 10 May 2017 (2017-05-10) entire document | 1-11 |
| A | CN 102569927 A (HUAWEI TECHNOLOGIES CO., LTD.) 11 July 2012 (2012-07-11) entire document | 1-11 |
| A | CN 110098646 A (NINGDE AMPEREX TECHNOLOGY LTD.) 06 August 2019 (2019-08-06) entire document | 1-11 |
| A | CN 110071339 A (VOLKSWAGEN AG) 30 July 2019 (2019-07-30) entire document | 1-11 |
| A | WO 2021056690 A1 (NINGDE AMPEREX TECHNOLOGY LTD.) 01 April 2021 (2021-04-01) entire document | 1-11 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **12 May 2022** | **27 May 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/117307**

| Patent document cited in search report | | | Publication date (day/month/year) | Patent family member(s) | | | Publication date (day/month/year) |
|---|---|---|---|---|---|---|---|
| CN | 111279573 | A | 12 June 2020 | WO | 2020124521 | A1 | 25 June 2020 |
| CN | 106663957 | A | 10 May 2017 | TW | 201733238 | A | 16 September 2017 |
| | | | | US | 2017256961 | A1 | 07 September 2017 |
| | | | | ES | 2772999 | T3 | 09 July 2020 |
| | | | | EP | 3242373 | A1 | 08 November 2017 |
| | | | | WO | 2017147791 | A1 | 08 September 2017 |
| | | | | IN | 201737003387 | A | 10 November 2017 |
| | | | | TW | 621320 | B1 | 11 April 2018 |
| | | | | EP | 3242373 | A4 | 18 April 2018 |
| | | | | US | 10084333 | B2 | 25 September 2018 |
| | | | | CN | 106663957 | B | 23 August 2019 |
| | | | | EP | 3242373 | B1 | 08 January 2020 |
| | | | | IN | 368063 | B | 04 June 2021 |
| CN | 102569927 | A | 11 July 2012 | | None | | |
| CN | 110098646 | A | 06 August 2019 | US | 2019237974 | A1 | 01 August 2019 |
| | | | | US | 11056900 | B2 | 06 July 2021 |
| CN | 110071339 | A | 30 July 2019 | DE | 102018200976 | A1 | 25 July 2019 |
| WO | 2021056690 | A1 | 01 April 2021 | EP | 3843234 | A1 | 30 June 2021 |
| | | | | JP | 2022503814 | A | 12 January 2022 |
| | | | | CN | 112583060 | A | 30 March 2021 |
| | | | | IN | 202117015239 | A | 09 April 2021 |

Form PCT/ISA/210 (patent family annex) (January 2015)